# NEUE EUROPÄISCHE PATENTSCHRIFT

(11) **EP 0 306 612 B2**
(45) Veröffentlichungstag und Bekanntmachung des Hinweises auf die Entscheidung über den Einspruch: **28.02.1996**
(45) Hinweis auf die Patenterteilung: 17.07.1991
(21) Anmeldenummer: 88106546.0
(22) Anmeldetag: 23.04.1988
(51) Int. Cl.: C23C 14/22, C23C 14/35, C23C 14/30

(54) **Verfahren zur Aufbringung von Schichten auf Substraten**
Process for depositing layers on substrates
Procédé de déposition de couches sur des substrats

(30) Priorität: 26.08.1987 CH 3275/87
(43) Veröffentlichungstag der Anmeldung: 15.03.1989
(73) Patentinhaber: BALZERS AKTIENGESELLSCHAFT, FL-9496 Balzers (LI)
(72) Erfinder: Bergmann, Erich, Dr., CH-8887 Mels (CH)
(74) Vertreter: Keller, René, Dr.

(56) Entgegenhaltungen:
- DD-A- 0 246 571
- DE-A- 2 417 288
- DE-A- 3 409 342
- FR-A- 2 393 079
- US-A- 4 415 421
- R.F. Bunshaw et al.: "Deposition Technologies for Films and Coatings", NDYES Publ., Park Ridges, New Jersey, USA, Seite 106

## Beschreibung

Vakuumbeschichtungen haben sehr vielseitige Anwendungen, die den Aufbau von Schichtstrukturen auf Halbleiterkomponenten, die optische Vergütung von Linsen, Spiegeln und den Verschleiss- und Korrosionsschutz von Maschinenelementen und Werkzeugen umfassen. Hinzu kommen eine Vielzahl von speziellen Problemlösungen im Maschinenbau und in der Elektrotechnik, die mit Hilfe von Vakuumbeschichtungen möglich sind. Traditionell werden zwei grundsätzliche Varianten der Vakuumbeschichtung unterschieden: Die chemischen Beschichtungsverfahren, bei der die die flüchtigen Verbindungen aller die Schicht bildenden Elemente in eine Kammer eingelassen und durch geeignete Mittel - wie Temperaturerhöhung, elektrisches Plasma oder Licht - an der Oberfläche der Substrate zur Reaktion gebracht werden. Bei der physikalischen Beschichtung dagegen werden wenigstens die Metallkomponenten der Elemente, die die Schicht bilden sollen erst im Vakuum der Kammer in die Dampfform übergeführt und kondensieren dann an den Substraten. Durch Zuleiten von entsprechenden reaktiven Gasen können auch kondensierte Schichten aus Oxiden, Sulfiden, Karbiden, Nitriden, Siliciden, Boriden bzw. deren Mischverbindungen wie Karbonitriden erhalten werden. Im Gegensatz zu den chemischen Beschichtungsverfahren werden hiebei also nur die Metalloidkomponenten in Gasform in die Beschichtungskammer eingeleitet. Bei anderen physikalischen Beschichtungsverfahren wiederum werden die die gewünschte Schicht bildenden Verbindungen, also die Oxide, Fluoride oder Sulfide im Vakuum der Kammer in die Dampfform übergeführt. Die vorliegende Erfindung betrifft ein Verfahren zur physikalischen Beschichtung.

Zur Ueberführung des festen Beschichtungsgutes in die Dampfform haben sich zwei Vorgangsweisen bewährt (siehe Thin film processes, Vossen J. L. und Kern W. eds. Academic Press 1978); nämlich die Zerstäubung von Kathoden im Plasma durch auftreffende Ionen und die Erwärmung des Verdampfungsgutes, wobei es schmilzt und entweder verdampft oder sublimiert.

Betreffend die Kathodenzerstäubung hatte man schon früh entdeckt, dass magnetische Felder, deren Flusslinien in Kathodennähe zu den elektrischen Feldlinien orthogonal sind, die Zerstäubungsspannung wesentlich zu senken und die Materialausbeute, also die Masse des abgetragenen Schichtmaterials pro Energiemenge zu steigern vermögen.

Auch wurden bereits verschiedenste Einrichtungen zur Verdampfung oder Sublimation entwikkelt: Beheizte Schiffchen, Hochspannungselektronenkanonen und insbesondere in den letzten Jahren Einrichtungen für die Verdampfung der Elektroden von Bogenentladungen. Für die Durchführung der vorliegenden Erfindung sind nun die Verdampfungsverfahren bei denen eine der beiden Elektroden einer Bogenentladung verdampft bzw. absublimiert wird, sowie die magnetfeldunterstüzte Kathodenzerstäubung von Interesse.

Trotz der grossen Vielfalt von Beschichtungsverfahren konnten zahlreiche Probleme der Beschichtungstechnik bis heute nicht befriedigend gelöst werden. So ist es bis heute nicht möglich, kompakte isotrope Feinstverteilungen aus mehreren Komponenten herzustellen. Auch ist noch immer unmöglich, gute und glatte Schichten aus ternären- oder polynären Verbindungen mit mehr als einer Metallkomponente herzustellen. Zu diesen beiden grossen Problemgruppen, die die Realisation zahlreicher Anwendungen verhindern, kommen aber noch eine Fülle von Einzelproblemen aus dem Alltag der Beschichtungstechnik, die dem Fachmann wohlbekannt sind und für die das erfindungsgemässe Verfahren eine Lösung bringt, wie weiter unten ersichtlich wird.

Es gibt zur Zeit im wesentlichen drei Verfahren der Verdampfung oder Sublimation von Elektroden von Bogenverdampfungen (E. Moll, US-PS 4 197 175, C. Bergmann, US-PS 4 556 471).

Beim Verfahren, bei dem Metalldampf durch einen sich auf einer gekühlten Kathode einer Bogenentladung bewegenden Kathodenfleck (Funken) verdampft bzw. sublimiert wird - im folgenden kurz Kathodenfleckverdampfung genannt - treten Spritzer auf, die nur vermieden werden können, indem man unter hohem Restgasdruck die Kathodenoberflächen während der Verdampfung laufend gleichzeitig reaktiv mit einer Verbindung beschichtet (siehe EP-A-285745) oder indem man durch geeignete Magnetfelder den Bogen bei niedriger Leistung stabilisiert, was allerdings die Wirtschaftlichkeit beschränkt. Schichten mit Spritzern haben sich aber in den meisten Anwendungen als ungeeignet herausgestellt.

Beim Verfahren, bei dem der Metalldampf dadurch erzeugt wird, dass mittels einer beheizten Kathode in einer lonisationskammer ein dichtes Plasma erzeugt wird,aus dem ein Niedervoltbogen auf einen das Verdampfungsgut enthaltenen Tiegel gezogen wird, um mit der Energie seiner aufprallenden Elektronen dieses zu erwärmen und so den notwendigen Metalldampf zu liefern, eignen sich nur wenige Metalle als Anodenmaterial, da die Wärmeerzeugung an der Anode für das Schmelzen der meisten Metalle nicht ausreicht.

Mit einem weiteren bekannten Verfahren, bei dem der Metalldampf dadurch erzeugt wird, dass zwischen einer gekühlten Kathode und einer bezüglich ihrer Fläche kleineren Anode eine Bogenentladung mit so hoher Stromdichte erzeugt wird, dass die Anode verdampft bzw. sublimiert, wobei dieser Dampf zur Aufrechterhaltung des Plasmas in der positiven Säule der Bogenentladung ausreicht, ist es bis heute nicht gelungen, zeitlich stabile Verdampfer zu bauen, die eine industrielle Beschichtung allein mit dieser Quelle ermöglichen würden.

Auch die Kathodenzerstäubung führt in vielen Fällen nicht zu kompakten Schichten (E. Bergmann US-PS 4 557 981) und die Prozessführung bei reaktiven Verfahren ist dabei schwierig; oft liefert das reaktive Aufstäuben in der bisherigen Form submikroporöse Schichten, die für manche Anwendungen unbrauchbar sind.

Bekannt ist es im weiteren, verschleissfeste bogenverdampfte Titan-Schichten mit einer kathodenzerstäubten Goldschicht zu verschönern. Dabei wird für ein möglichst goldenes Aussehen der Titan-Schicht und ein gutes Haften der Goldschicht auf der Titan-Schicht Sorge getragen.

Die US-A 4 415 421 (Citizen Watch) befasst sich mit einem derartigen Vergolden von Uhrengehäusen und anderen Schmuckgegenständen. Dabei wird zuerst eine (verschleissfeste) Titan- oder TiN-Schicht mittels eines Elektronenstrahlverdampfers bzw. Plasma-Hohlkathoden-Bogenentladungsverdampfers auf das Uhrengehäuse aufgedampft und anschliessend eine reine Goldschicht mit Hilfe einer Magnetron-Sputterquelle aufgesputtert. Beim Abschalten des Verdampfers und Einschalten der Sputterquelle entsteht zwischen den beiden Schichten eine Zwischenschicht mit stetig ansteigendem Goldgehalt und stetig abfallendem Titan- bzw. Titannitridgehalt.

Mit einer Verschönerung der verschleissfesten Bogenverdampfungs-Schicht befasst sich auch die DD-A 246 571. Sie setzt sich kritisch mit dem Verfahren nach US-A 4 415 421 auseinander, wobei sie namentlich die vom Verdampfer unabhängige, magnetfeldunterstützte Kathodenzerstäubung rügt, die ebenso wie jener ihr verfahrensbedingtes Plasma benötige, welches bei Magnetronquellen stark an das Target gebunden sei, wodurch negative Beeinflussungen aufträten.

Demzufolge wirkt bei der DD-A 246 571 der Bogenentladungsverdampfer als einziges, zentrales Plasmaerzeugungssystem und die Sputtereinrichtung besteht lediglich aus einem potential-variablen Target und einer Targetabschirmung ohne jegliche Magnetfeldunterstützung. Das Hauptmaterial (TiN) der Schicht wird in der Bogenentladung verdampft. Sputtern lässt sich demgegenüber nur eine geringe Menge des zur Verschönerung der Schicht dienenden Legierungs- bzw. Dotierungsmaterial (Ag).

Die Erfindung befasst sich mit einem grundsätzlich anderen Problem, nämlich der Verbesserung der Verschleissfestigkeit gesputterter Schichten. Ihre Aufgabe ist es dementsprechend, kompaktere und dichtere Schichten herzustellen als dies bisher mittels Kathodenzerstäubung möglich erschien.

Die erfindungsgemässe Lösung der Aufgabe ist Gegenstand des Patentanspruchs 1. Bevorzugte Ausführungsarten sind in den Ansprüchen 2 bis 6 umschrieben.

Offenbar infolge eines synergistischen Effekts lassen sich durch die ständige oder in rascher Folge alternierende Schichtbildung aus Material der Bogenentladung und der davon unabhängigen, magnetfeldunterstützten Kathodenzerstäubung die Probleme der Bogenverdampfung und Kathodenzerstäubung lösen und Schichten von größerer Dichte und Kompaktheit herstellen.

Für die Wahl des optimalen Anteils an Metalldampf, welcher der Verdampfung der Elektroden in der Bogenentladung zu entnehmen ist, gelten Gesichtspunkte, die anhand der unten folgenden Beispiele noch näher erläutert werden. Im allgemeinen richtet sich der notwendige Anteil dieses Dampfes vor allem nach dem Material, das als Schicht niedergeschlagen werden soll. Beim Abscheiden von sehr refraktären Metallen beispielsweise benötigt man einen höheren Anteil an Dampf aus der Bogenentladung, um kompakte Schichten herzustellen, als für Schichten aus niedrigschmelzenden Metallen. Auch gilt, dass, je tiefer die Temperatur des Substrates bei der Beschichtung sein soll, desto höher der Anteil an Dampf aus der Bogenentladung gewählt werden muss. Als Richtschnur kann die Theorie betreffend Kathodenzerstäubungsschichten von John A Thornton, J. Vac. Sci. Technol., Vol. 11, No. 4, July/.Aug. 1974 gelten. Ueberraschend ist, dass der Anteil an Bogenentladungsdampf viel niedriger sein kann, als man hätte erwarten können. Bei Anwendung einer reaktiven Restgasatmosphäre in der Vakuumkammer bei der Aufbringung der Schichten wird man den Anteil an Bogenentladungsdampf um so höher wählen, je höher die Aktivierungsenergie der Oxidationsreaktion des Metalles ist, das eine Verbindung mit dem Metalloid eingehen soll. Im Allgemeinen hat sich gezeigt, dass ein Anteil von 5% von Dampf aus der Bogenentladung bereits ausreicht, um die Schichten kompakt werden zu lassen, die, wenn sie mit reiner Kathodenzerstäubung hergestellt würden, eine Stengelstruktur aufweisen. Grössere Anteile können notwendig sein, wenn die Anforderungen an die Schicht höher sind (z.B. Isotropie im Bereich von 10 nm verlangt wird).

Es ist dem Fachmann selbstverständlich klar, dass sich der notwendige Anteil von Bogenentladungs-Elektrodendampf nur auf die zu beschichtenden Funktionsflächen bezieht. Im allgemeinen wird ein Bauteil drei Arten von Flächen aufweisen, nämlich solche, auf denen die Schicht eine bestimmte Funktion erfüllen muss, andere Funktionsflächen, auf denen keine Schicht aufgetragen werden darf, weil die Eigenschaften des Grundwerkstoffes an der Oberfläche benötigt werden, und Flächen, auf denen die Beschichtung und die Qualität der Schicht eine geringere oder keine Rolle spielt.

Nun ist es allerdings nicht immer möglich, Vakuumbedampfungsanlagen so zu bauen, dass die zu beschichtenden Funktionsflächen zu jedem Zeitpunkt sowohl dem Dampf aus der Verdampfung oder der Sublimation der Kathode oder Anode einer Bogenentladung als auch dem von der Zerstäubungsquelle herrührenden zerstäubten Material ausgesetzt sind. Es hat sich aber gezeigt, dass es auch ausreicht, wenn die Substrate abwechselnd in rascher Folge wenigstens einer verdampfenden Bogenentladungselektrode und der Zerstäubungsquelle ausgesetzt sind. Im Falle einer solchen wechselnden Beschichtung muss dann über die Bewegung dafür gesorgt werden, dass die Perioden, bei denen der Niederschlag von Metalldampf auf den zu beschichtenden Funktionsflächen zu mehr als 95 von 100 Teilen aus der magnetfeldunterstützten Kathodenzerstäubung herrührt, so kurz sind, dass sich jeweils während der Einzelperioden nicht mehr als eine 30 Nanometer dicke Teilschicht niederschlagen kann. Das hohe Streuvermögen vieler bekannter Einrichtungen zur Bogenentladungsverdampfung, erleichtert es, diese Bedingung einzuhalten.

Im folgenden werden Ausführungsbeispiele des erfindungsgemässen Verfahrens anhand der Zeichnungen näher erläutert. Die in den Zeichnungen dargestellten Vorrichtungen sind nicht Gegenstand der Patentansprüche und dienen insofern nur zur Erläuterung der erfindungsgemässen Verfahrensbeispiele.
Figur 1 zeigt zunächst ein einfaches Ausführungsbeispiel einer Vorrichtung zur Durchführung des erfindungsgemässen Verfahrens, bei dem auf dem Boden einer Vakuumbeschichtungskammer nebeneinander eine oder mehrere Stationen zur magnetfeldunterstützten Kathodenzerstäubung und eine oder mehrere Stationen zur elektrischen Bogenverdampfung angeordnet sind;
Figur 2 zeigt eine weitere Beschichtungsanlage, bei welcher eine Mehrzahl von als sogenannte Zerstäubungsmagnetrons ausgebildeten Kathodenzerstäubungseinrichtungen um eine zentrale Niedervoltbogenverdampfungseinrichtung herum angeordnet sind;
Figur 3 betrifft eine ähnliche Anlage, wobei jedoch anstelle eines Niedervoltbogenverdampfers ein sogenannter Kathodenfleckverdampfer eingesetzt ist, bei dem in einer elektrischen Bogenentladung Material von der Kathode abgedampft wird;
Figur 4 schliesslich zeigt schematisch den Aufbau einer Durchlaufbeschichtungsanlage mit einer Mehrzahl von Zerstäubungsmagnetrons und Kathodenfleckverdampfern, die in ein und derselben Vakuumkammer je einander gegenüber stehend die abwechselnde Beschichtung der durchlaufenden Substrate durch kathodische Zerstäubung und durch magnetfeldunterstützte Niederspannungsentladung besorgen.

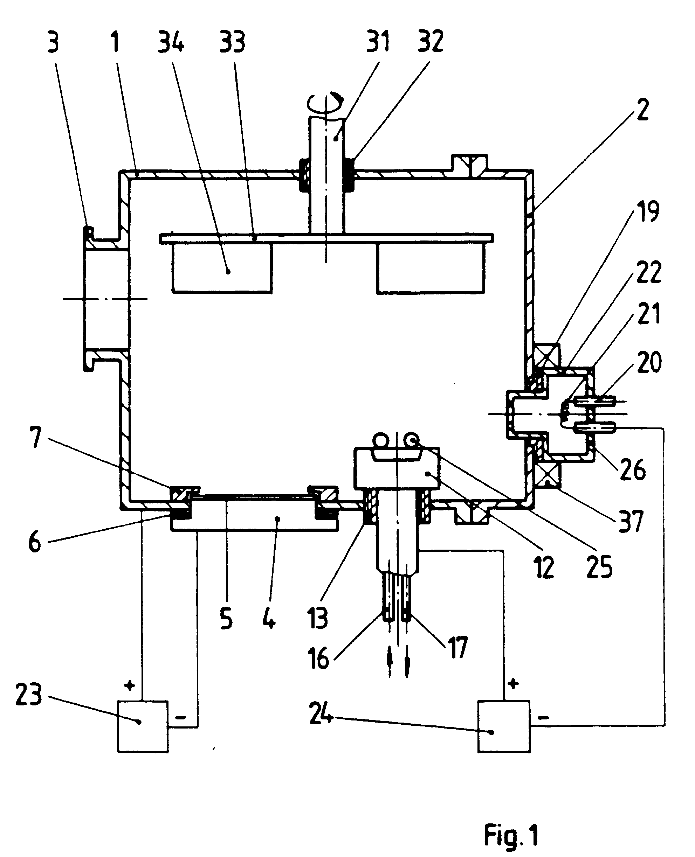

Mit der Anlage nach der Figur 1 ist es möglich, die Substrate ständig sowohl durch die Verdampfung der Anode einer Bogenentladung wie auch durch Verdampfung aus einer magnetfeldunterstützten Kathodenzerstäubung zu beschichten. Die Beschichtungskammer ist als rechteckige Kammer 1 ausgebildet, die über einen nicht dargestellten Pumpstand, der an den Flansch 3 angeschlossen wird, evakuiert werden kann. An einer Seitenwand 2 der Kammer ist eine lonisationskammer 26 für die Durchführung einer sogenannten Niedervoltbogenentladung angeflanscht. Als Anode für diese Entladung dient ein Verdampfungstiegel 12, der von der Kammer durch Flansche aus Isoliermaterial 13 elektrisch getrennt ist, und durch einen Wasserdurchfluss 16, 17, gekühlt ist, in den das zu verdampfende Material 25 eingelegt wird. Einer der beiden Anschlüsse ist mit dem positiven Pol des Bogenentladungsspeisegerätes 24 verbunden. Der Tiegel wird beim Betrieb von den aus der Niedervoltbogenentladung auf ihn auftreffenden Elektronen erhitzt. Nähere Einzelheiten zum Aufbau einer solchen Niedervoltbogenverdampfungsstation sind z.B. in der schweizerischen Patentschrift 631 743 dargelegt. Zur Fokussierung des Bogens dient das Magnetfeld einer oder mehrerer Spulen, 37.

Neben der Verdampferquelle 12 ist am Boden der Vakuumkammer auch eine Station 4 zur magnetfeldunterstützten Kathodenzerstäubung angeordnet. Letztere weist einen gekühlten Grundkörper auf, der das erforderliche Magnetsystem enthält und an dessen dem Vakuumraum zugewandten Seite ein Zerstäubungstarget 5 befestigt ist. Der Grundkörper ist in an sich bekannter Weise durch den Ring 6 von der Kammer elektrisch isoliert und an den negativen Pol einer Spannungsquelle 23 angeschlossen, deren positiver Pol mit der Kammerwand verbunden ist. Das Plasma der Kathodenzerstäubungs-Entladung wird durch eine Anode 7 begrenzt, die mit der Kesselwand leitend verbunden sein kann. Beim Betrieb wird das Targetmaterial zerstäubt und auf den Substraten 34, die auf einem Drehteller 33 in der Kammer angeordnet sind, niedergeschlagen. Die Rotation des Drehtellers um die Achse 31 sorgt dafür, dass die Substrate gleichmässig beiden Dampfquellen ausgesetzt werden. Er ist gegenüber der Kammerwand durch ein Zwischenstück 32 elektrisch isoliert, damit erwünschtenfalls eine elektrische Vorspannung an die Substrate angelegt werden kann. Bezüglich Einzelheiten betreffend den Aufbau von magnetfeldunterstützten Kathodenzerstäubungseinrichtungen siehe z.B. US-PS 4 166 018.

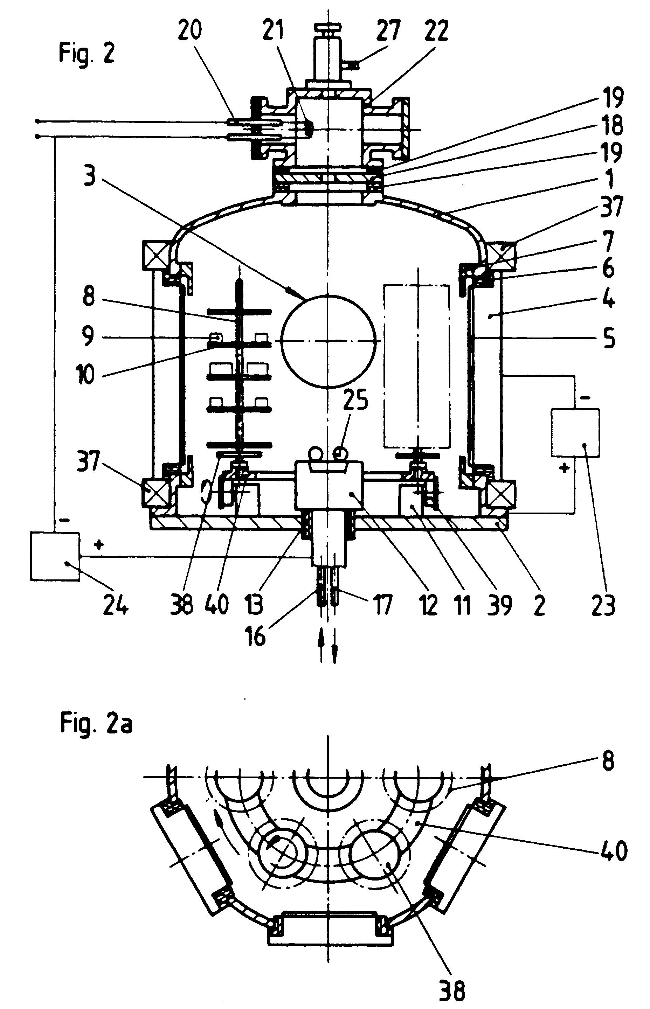

In der Anlage nach Fig. 2 sind mehrere Quellen zur magnetfeldunterstützten Kathodenzerstäubung mit einer zentralen Bogenverdampfungseinrichtung und einer lonisationskammer für den Betrieb des Bogens kombiniert. Ein Kessel 1 ist auf einer Grundplatte 2 aufgesetzt und bildet mit dieser zusammen die Vakuumkammer. An den Seiten des Kessels sind fünf Flansche vorgesehen, an denen je ein Zerstäubungs-Magnetron zur magnetfeldunterstützten Kathodenzerstäubung 4 angeflanscht werden kann. Sie sind durch einen Zwischenflansch aus einem geeigneten Isolationsmaterial 6 von der Kammer elektrisch isoliert. Auf der dem Innenraum zugewandten Seite eines jeden Zerstäubungsmagnetrons ist wiederum ein Target 5 aus dem Material, das die Schicht mitkonstituieren soll, befestigt, z.B. aufgeklemmt. Die zahlreichen Möglichkeiten für derartige Verbindungen sind in der Fachliteratur beschrieben. Die in den nachfolgenden Verfahrensbeispielen dargelegten Versuche wurden mit direkt gekühlten Targets durchgeführt. Das Plasma der Kathodenzerstäubungs-Entladung wird durch eine Anode 7 begrenzt, die mit der Kesselwand leitend verbunden sein kann. Jede dieser Zerstäubungsstationen ist individuell an ein Gleichstromspeisegerät 23 angeschlossen.

Bei der Anlage der Figur 2 ist die lonisationskammer 22 auf die Vakuumkammer aufgesetzt und von der Hauptkammer 1 durch eine isoliert gehalterte Lochblende 18 getrennt. Diese zwischen der lonisationskammer 22 und der Beschichtungskammer 1 befindliche durch Ringe 19 isolierte Blende beschränkt den Plasmaaustausch zwischen den beiden Kammern. In der lonisationskammer ist ein Glühfaden 21 aus einer geeigneten refraktären Legierung, z.B. Wolfram oder Tantal vorgesehen und über Stromdurchführungen 20 an eine Heizstromversorgung anschliessbar. Einer der beiden Anschlüsse ist mit dem negativen Pol des Bogenentladungsspeisegerätes 24 verbunden. Ueber eine Zuleitung 27 wird das für die Entladung erforderliche Edelgas der lonisationskammer zugeführt. Die Funktionsweise und weitere Einzelheiten des Aufbaues und Betriebes von Einrichtungen für die Durchführung einer Niedervoltbogenverdampfung und magnetfeldunterstützten Kathodenzerstäubung sind aus der CH-PS 631 743 bzw. er US-PS 4 166 018 bekannt. Die Evakuierung der Anlage erfolgt über einen Flansch 3 für den Anschluss eines Pumpstandes. Für die Bogenverdampfung ist weiter ein Tiegel 12 erforderlich, der mit einer Kühleinrichtung mit den Anschlussrohren 16 und 17 zur Zuführung und Abführung eines Kühlemittels versehen ist und durch einen Flansch aus Isolationsmaterial 13 von der übrigen Anlage elektrisch isoliert und der an den positiven Pol des Bogenentladungs-Gleichspannungsspeisegerätes 24 angeschlossen ist.

Zur Verdampfung eines Teiles des schichtaufbauenden Materials werden Stücke 25 desselben z.B. in Tablettenform in den Tiegel gelegt und wird die Niedervoltbogenentladung mittels eines axialen Magnetfeldes, zu dessen Erzeugung die Spulen 37 vorgesehen sind, darauf fokussiert. Die Substratträger 8 sind zwischen dem Verdampfungstiegel und den Quellen 4 zur magnetfeldunterstützen Kathodenzerstäubung angeordnet. Es sind z.B. sechs solche Träger vorgesehen.

An jedem dieser Träger sind z.B. Teller 10 angebracht, die ihrerseits die Substrate 9 tragen. Bei der Beschichtung werden die Träger fortwährend auf einer Kreisbahn um den Niedervoltbogen herum und gleichzeitig an den an der zylindrischen Kammerwand angeordneten Zerstäubungsquellen vorbeigeführt. Dazu kann ein sogenanntes Karussell 38 oder Drehgestell dienen, das z.B. aus einem auf Rollen 39, drehbar gelagerten horizontalen Ring 40 besteht, an dem die vertikalen Träger aufmontiert sind und der durch einen Motor 11 angetrieben wird. Zweckmässig ist es auch, die Substratteller, während sie auf einer Kreisbahn sich bewegen, gleichzeitig in eine kontinuierliche oder intermittierende Drehung um ihre vertikale Achse zu versetzen, um eine gleichmässige Beschichtung aller auf jedem Teller angeordneten Substrate zu erreichen.

Die Figur 2a zeigt einen Grundriss der Figur 2 und lässt erkennen, dass bei dieser Anlage insgesamt fünf Zerstäubungs-Magnetrons zusammen mit dem Absaugstutzen 3 an den Seitenwänden des Kessels und ein Drehgestell mit sechs Tragsäulen für Substratteller Platz finden.

Anstelle der Niedervoltbogenverdampfungseinrichtung in Figur 2 könnten auch ein oder mehrere der vorhandenen Flansche an der Mantelfläche mit Kathodenfleckverdampfern bestückt werden.

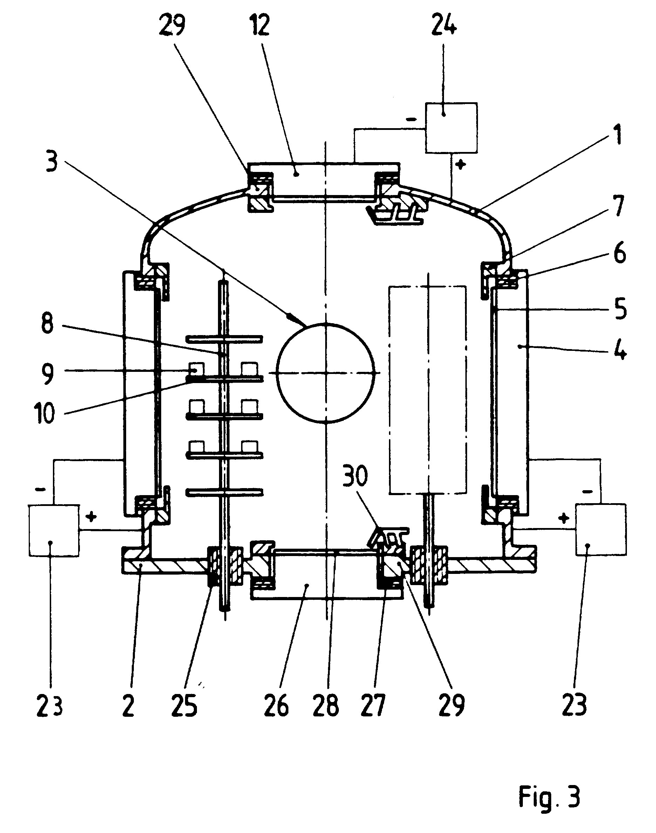

Die Figur 3 zeigt eine weitere Anlage wiederum mit fünf Flanschen für Zerstäubungs-Magnetrons 4 am zylindrischen Teil des Kessels. Am Boden und an der Decke der Kammer 1 sind Flansche 29 aufgeschweisst, auf denen je eine Station zur Bogenentladungskathodenfleckverdampfung 12 angebracht ist. Sie bestehen aus einem wassergekühlten Grundkörper 26, der von der Kammerwand funkentechnisch isoliert ist. Einzelheiten, wie diese Isolation 27 ausgeführt werden muss, sind dem Fachman bekannt (z.B. W.M. Mularie US Patent 4 430 184, C. Bergmann, G.E.Vergason, W. Allen, N.F. Reed US Patent 4 556 471). Auf den dem Kammerinnern zugewandten Seiten, sind Platten 28 aus dem zu verdampfenden Kathodenmaterial angebracht. Hinzu kommen je eine Triggereinrichtung 30. Die Einzelheiten dieser Ausführung sind dem Fachmann ebenfalls bekannt. (C. Bergmann, R. Clark, G.E. Vergason, S. Bosark deutsche Offenlegungsschrift 34 13 728). Die Leistungsversorgung der beiden Kathodenfleckbogenverdampfer geschieht mit je einem Schweissgenerator 24. Seine Anode kann entweder, wie im Bild gezeigt, an die Kesselwand angeschlossen werden oder als Teil der Isolierung 27 zwischen Kathode und Kessel ausgebildet werden. Vor jeder Station 4 zur magnetfeldunterstützten Kathodenzerstäubung befindet sich ein achsenförmiger Träger 8, der von der Grundplatte 2 durch eine Isolation 25 elektrisch getrennt ist. Auf ihm werden die zu beschichtenden Werkstücke 9 angebracht. z.B. auf Zwischtentellern 10. Ihre Rotation um die eigene Achse wird so rasch gewählt, dass die Funktion der auf den Targets und den Bogenelektroden aufgebrachten Leistungen die 30-Nanometer-Bedingung gemäss Anspruch 3 erfüllt werden kann.

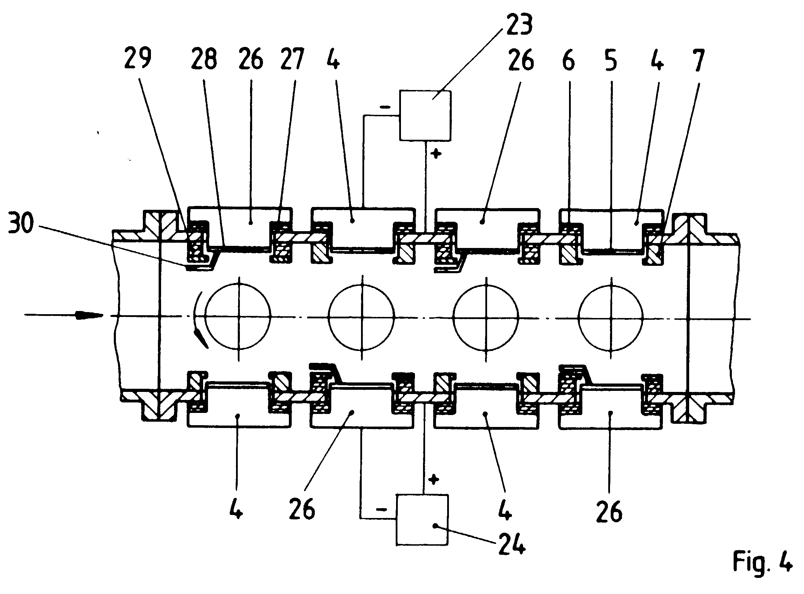

Die in Fig. 4 gezeigte Anlage ist, wie oben erwähnt, eine Durchlaufanlage, bei der die Substrate kontinuierlich in die Beschichtungskammer eingeschleust, durch die Beschichtungszone hindurchgeführt und nach der Beschichtung wieder ausgeschleust werden können. In der Zeichnung dargestellt ist lediglich die eigentliche Beschichtungskammer mit vier Zerstäubungs-Magentrons 4 und vier Kathodenfleckverdampfern 26, wobei je ein Zerstäubungs-Magnetron und ein Funkenverdampfer einander gegenüberliegend angeordnet sind. Die Geschwindigkeit des Durchlaufs der Substrate ist dabei bei Durchführung des Verfahrens nach Anspruch 3 wiederum so zu wählen, dass die "30 nm-Bedingung" eingehalten werden kann.

Es folgen nun einige Beispiele für die Verfahrensausübung: In einem ersten Verfahrenssbeispiel bestand die Aufgabe darin, Schichten aus Ti_{0,6}Al_{0,4}N so herzustellen, dass sie als die Standzeit verlängernde Beschichtungen für Schneidwerkzeuge geeignet sind. Als Prüfmethode wurde das Bohren von 8 mm tiefen Sacklöchern, Durchmesser 6 mm, in Grauguss, GG 30, gewählt. Die Bohrbedingungen waren: Schnittgeschwindigkeit 30 m/Min, Vorschub 0,2 mm/Umdrehung. Unter diesen Bedingungen lassen sich mit einer mittels Niedervoltbogen herkömmlich aufgedampften reinen Titannitridschicht von 3 µm Dicke 120 Löcher bohren, bevor der Verschleiss so gross wird, dass die Lochqualität ausserhalb der Qualitätsanforderungen liegt. Versuche, eine Legierung aus Titan und Aluminium zu verdampfen, schlugen fehl.

In einem weiteren Vorversuch wurden 4 Stationen einer Anlage zur magnetfeldunterstützten Kathodenzerstäubung mit Titantargets bestückt und 4 weitere derartige Stationen mit Aluminiumtargets. Die Zerstäubung wurde in einem Argon-Stickstoff-gemisch betrieben und so gewählt, dass sich auf den Bohrern 3 µm Ti_{0,6}Al_{0,4}N abschied. Trotz aller Versuche, die Zerstäubung zu optimieren, zeigte die Schicht ein unerwünschtes stengeliges Wachstum und der Bohrversuch musste nach 15 Loch abgebrochen werden. Danach wurden die Bohrer nach dem erfindungsgemässen Verfahren beschichtet und zwar wie folgt: 4 Stationen zur magnetfeldunterstützten Kathodenzerstäubung der Anlage wurden mit Titantargets bestückt und 4 Stationen mit Aluminiumtargets. Der anodisch geschaltete Verdampfungstiegel einer in der gleichen Anlage befindlichen Bogen-Verdampfungseinrichtung wurde mit Titantabletten beladen und das als Haltevorrichtung für die zu beschichtenden Substrate in der Anlage vorhandene Karussell mit Bohrern. Nach den üblichen Vorbereitungsschritten: Pumpen, Heizen, Aetzen, die dem Fachmann bekannt sind, wurde das Karussell in Betrieb gesetzt und zwar mit einer Umlaufgeschwindigkeit von 2 Umdrehungen pro Minute. Dabei wurden die Achsenhalterungen durch eine Hilfseinrichtung, wie sie z.B. in der US-PS 29 12 351 beschrieben ist, alle Minuten um wenigstens 180 Grad gedreht. Danach wurde in der Kammer ein Argondruck von 0,15 Pascal eingestellt und zwischen der Glühkathode der Niedervolt-Bogenentladungseinrichtung und dem Tiegel gezündet und mittels eines magnetischen Feldes auf den Tiegel fokussiert. Die Stromstärke betrug 120 Ampere und die Spannung 51 Volt. In wenigen Sekunden setzte die Titanverdampfung aus dem Tiegel ein, danach wurde Stickstoff zugelassen und zwar 60 Normkubikzentimeter pro Minute. Sobald der Stickstofffluss stabilisiert war, wurden auch die 8 Stationen zur magnetfeldunterstützten Kathodenzerstäubung eingeschaltet und die Titantargets wurden mit je 23 Ampere zerstäubt, ebenso die 4 Aluminiumtargets mit je 20 Ampere. Der Stickstoffluss wurde dann auf 250 Normkubikzentimeter pro Minute erhöht und der Gesamtdruck erhöhte sich dabei auf 0,3 Pascal. Nach 24 Minuten wurde die Beschichtung abgebrochen und auf den Bohrern fand sich eine 3 µm Dicke Schicht, deren Zusammensetzung mittels energiedispersiver Röntgen-Analyse semiquantitativ als Ti_{0,6}AL_{0,4}N bestimmt wurde. Aus einem Vergleich mit den Abscheideraten von Titannitrid unter ähnlichen Bedingungen konnte der Anteil des bogenverdampften Materials bestimmt werden. Er betrug 8 Atomprozente. Die Bohrer wurden wie oben getestet und erzielten 170 Loch. Eine Kontrolle im Rasterlektronen-Mikroskop zeigte eine vollkommen kompakte Schicht. In einem weiteren Versuch wurden 160 Ampere für den Bogenstrom gewählt, was eine etwa doppelt so hohe Verdampfungsgeschwindigkeit ergibt und alle übrigen Bedingungen wurden gleich gewählt und die Bohrer wieder unter gleichen Bedingungen getestet, wobei sie 190 Loch erbrachten, also nur eine unwesentliche Verbesserung ergaben.

In einem weiteren zweiten Beispiel bestand die Aufgabe ebenfalls darin, Schichten aus Titannitrid so herzustellen, dass sie für Schneidwerkzeuge geeignet sind. Die Prüfmethode war die gleiche wie im Beispiel 1. Die Bohrer wurden mit dem erfindungsgemässen Verfahren beschichtet und zwar wie folgt: Alle Stationen zur magnetfeldunterstützten Kathodenzerstäubung der Anlage wurden mit Titantargets bestückt, der Tiegel mit Titantabletten beladen und das Karussell mit Bohrern bestückt. Nach den üblichen Vorbereitungsschritten: Pumpen, Heizen, Aetzen, die dem Fachmann bekannt sind, wurde das Karussell in Betrieb gesetzt und zwar mit einer Umlaufgeschwindigkeit von 2 Umdrehungen pro Minute. Bei dieser Geschwindigkeit werden die drehbaren Substrathalterungen alle Minuten um wenigstens 180 Grad gedreht. In der Kammer wurde ein Argondruck von 0,15 Pascal eingestellt, der Heizfaden der Niedervoltbogenentladung eingeschaltet und ein Bogen zwischen diesem und dem Tiegel gezündet und mittels eines magnetischen Feldes auf den Tiegel fokussiert. Die Stromstärke betrug dabei 80 Ampere, die Spannung 49 Volt; dabei setzte innert wenigen Sekunden die Titanverdampfung aus dem Tiegel ein. Danach wurde Stickstoff zugelassen und zwar 40 Normkubikzentimeter pro Minute. Sobald der Stickstofffluss stabilisiert war, wurden die in der verwendeten Anlagen vorhandenen 8 Stationen zur magnetfeldunterstützten Kathodenzerstäubung eingeschaltet und mit je 23 Ampere betrieben, der Stickstofffluss wurde auf 250 Normkubikzentimeter pro Minute erhöht wodurch der Gesamtdruck auf 0,3 Pascal angehoben wurde. Nach 24 Minuten konstanter Beschichtung wurden alle Speisegeräte abgeschaltet und auf den Bohrern befand sich eine 3 µm dicke Schicht aus Titannitrid.

Aus einem Vergleich der Abscheiderate von Titannitrid unter ähnlichen Bedingungen konnte der Anteil des bogenverdampften Materials bestimmt werden. Er betrug etwa 6 at %. Die Bohrer wurden wie oben beschrieben getestet und erzielten 95 Loch. Eine Kontrolle im Rasterelektronen-Mikroskop zeigt vollkommen kompakte Schichten; in einem Vergleichsversuch wurden auf herkömmliche Weise Bohrer nur mit magnetfeldunterstützter Kathodenzerstäubung mit Titannitrid beschichtet und zwar auch mit einer Schichtstärke von 3 µm. Diese Bohrer versagten aber schon nach 9 Loch.

In Beispiel 3 bestand das Problem darin Schichten Ti_{0,8}V_{0,2}N so herzustellen, dass sie zum Fräsen geeignet sind. Als Testbedingungen wurde gewählt:
Schlichtfräsern auf einer linearen Transfermaschine Werkzeug SPKN 1203 EDR mit 8 Zähnen, Drm. 200 mm
Werkstoff M40
Schnittgeschwindigkeit 150 m/Min.
Vorschub/Zahn 0,53 mm
Schnittiefe 2,3 mm
Schnittbreite 60 mm

Die Anlage ist in Figur 3 beschrieben. Zuerst wurde versucht diese Schichten nur mit magnetfeldunterstützter Kathodenzerstäubung herzustellen. Dabei erzielte man eine Standzeit von 280 Teilen, die unbeschichteten Fräser erzielten 90 Teile. Danach wurden die Fräser nach dem erfindungsgemässen Verfahren beschichtet. Die beiden Kathodenfleckverdampfer wurden mit Titantargets bestück, 6 der Stationen zur magnetfeldunterstützten Kathodenzerstäubung wurden mit Titantargets, 2 mit Vanadintargets bestückt. Nach den üblichen Vorbereitungsschritten wurde ein Druck von 6 Pascal in einem Argon-Stickstoff-Gemisch im Verhältnis von 1 zu 1 in der Kammer eingestellt, dann wurden die Kathodenfleckverdampfer gezündet und mit je 60 Ampere Strom betrieben, ihre Spannung betrug 42 Volt. Danach wurden die Stationen zur magnetfeldunterstützten Kathodenzerstäubung eingeschalten, die 6 Stationen zur Zerstäubung von Titan wurden mit 23 Ampere betrieben, die 2 Stationen zur Zerstäubung von Vanadin mit 25 Ampere. Der Druck wurde durch eine entsprechende Erhöhung des Gasgemischflusses konstant gehalten und das Karussell mit 3 Umdrehungen pro Minute, entsprechend einer Drehung des Substrathalters um wenigstens 180 Grad alle 40 Sekunden betrieben. Nach 25 Minuten wurden alle Speisegeräte abgeschaltet. Auf den Fräsern befand sich sodann eine um 5 µm dicke Schicht deren Zusammensetzung als Ti_{0,8}V_{0,2} bestimmt wurde. Aus einem Vergleich mit der Abscheiderate von bogenverdampften Titannitrid unter ähnlichen Bedingungen konnte der Anteil des bogenverdampften Materials in diesen Schichten bestimmt werden. Er betrug 7%, die Fräser wurden unter den gleichen Bedingungen getestet, die Standzeit betrug 420 Teile. Eine Kontrolle im Rasterelektronenmikroskop zeigte vollkommen kompakte Schichten.

Beim Beispiel 4 handelt es sich um das Problem der Korrosion von Bauteilen, wie sie in vielen Bereichen des Maschinenbaus Verwendung finden. Gewählt wurden runde Probekörper aus CK45 und einem Durchmesser von 40 mm. Als Test wurde ein Wechseltauchbad im Meerwasser gewählt, gemäss DIN 50900. Die Testdauer betrug 48 Stunden, gewählt wurde eine Anlage wie sie in Figur 1 dargestellt wurde. Die Proben befanden sich auf einem Drehteller. Als Targets der Stationen zur magnetfeldunterstützten Kathodenzerstäubung wurde Stahl 18/10 gewählt, der Tiegel wurde mit 5 Chromtabletten beladen, die Prozesse wurden alle in reinem Argon betrieben. Der Druck betrug 0,3 Pascal. Da die Abfolge der einzelnen Schritte denen der vorangehenden Beispiele gleicht, soll auf sie nicht näher eingegangen werden. Eine Verdampfung mit einem Bogenstrom von 150 Ampere, bei einem Zerstäubungsstrom von 20 Ampere führte zu einer wesentlich besseren Korrosionsbeständigkeit als die Beschichtung mit einer Kathodenzerstäubung.

Als Beispiel 5 sollten selbstschmierende Schichten aus Molybdändisulfid/Molybdänmischungen auf die Laufbahn von Stirnkugellagern aufgebracht weden, deren gute Verwendbarkeit im Maschinenbau bekannt ist. Das Problem dieser Schichten ist deren hoher Verschleiss in Tribosystemen mit einer relativen Feuchtigkeit über 85%. Ursache dieses Verschleisses ist die mangelnde Kompaktheit, die das Eindringen von Wasser durch Submikroporosität erlaubt. Zur Beschichtung wurde die in Figur 4 dargestellte Anlage verwendet. Dabei wurden 3 Stationen zur magnetfeldunterstützten Kathodenzerstäubung mit Targets aus Molybdändisulfid bestückt, eine der Stationen zur Kathodenfleckverdampfung mit einer Kathode aus Molybdän. Die Bewegung der Substrate war linear, wobei die achsenförmigen Träger eine rasche Zusatzrotation von 4 Umdrehungen pro Minute ausführten. Nach den üblichen Vorbereitungsschritten: Evakuieren, Heizen, Plasmaätzen, wurde in der Kammer ein Druck von 0,5 Pascal Argon eingestellt, danach wurde der Substratträger in Bewegung gesetzt und die Funkenkathode gezündet und mit 80 Ampere Bogenstrom betrieben. Kurz danach wurden auch die Stationen zur magnetfeldunterstützten Kathodenzerstäubung aktiviert und mit einem Strom von 10 Ampere betrieben. Die Geschwindigkeit der linearen Bewegung betrug 1 Meter pro Minute,nach dem Durchlauf hatte sich auf den Kugellagerlaufflächen eine Schicht von 1 µm niedergeschlagen, deren Zusammensetzung zwischen MoS_{1,}9 und MoS variierte. Getestet wurden die Kugellager, Drm. 30 mm mit 8 Kugeln von Drm. 2,5 mm und einer Last von 2 kg bei einer Rotationsgeschwindigkeit von 300 Umdrehungen pro Minute unter 95% relativer Luftfeuchtigkeit. Ihre Lebensdauer betrug 2 Stunden. Zum Vergleich wurden Schichten ähnlicher Zusammensetzung unter ähnlichen Bedingungen nur mit magnetfeldunterstützten Kathodenzerstäubung hergestellt. Unter den soeben erwähnten Testbedingungen trat nach 10 Minuten in den Laufflächen Schichtverlust ein.

## Patentansprüche

1. Verfahren zur Aufbringung von Schichten auf Substraten, bei dem in einer Vakuumkammer Schichtmaterial mittels wenigstens zweier verschiedener Einrichtungen in gasförmigen Zustand übergeführt und auf den Substraten unter Bildung einer Schicht niedergeschlagen wird, wobei ein Teil des Materials durch eine elektrische Bogenentladung und ein anderer Teil durch eine von der Bogentladung unabhängige, magnetfeldunterstützte Kathodenzerstäubung in die Dampfform übergeführt wird und im zeitlichen Mittel wenigstens fünf Atomprozente des auf die Funktionsflächen der Substrate aufzubringenden Metallanteiles aus der Ueberführung von Elektrodenmaterial der Bogenentladung in die Dampfform herrühren, wobei die Schicht auf den Funktionsflächen der Substrate ständing oder in rascher Folge alternierend aus Material der Bogenentladung und der Kathodenzerstäubung gebildet wird.

2. Verfahren nach Patentanspruch 1, wobei wenigstens 5 von 100 Atomen des auftreffenden, schichtbildenden Metallanteiles zu jedem Zeitpunkt aus der Ueberführung von Elektrodenmaterial der Bogenentladung in die Dampfform herrührt.

3. Verfahren nach Patentanspruch 1, wobei die Perioden, in denen der Niederschlag von Metalldampf auf den zu beschichtenden Funktionsflächen der Substrate zu mehr als 95 von 100 Teilen aus der magnetfeldunterstützten Kathodenzerstäubung stammt, so kurz sind, dass sich auf diesen Funktionsflächen während dieser Perioden nicht mehr als 30 Nanometer Schicht niedergeschlagen.

4. Verfahren nach Patentanspruch 1 wobei ein Teil des Metalles von der Kathode einer elektrischen Bogentladung in Dampfform übergeführt wird.

5. Verfahren nach Patentanspruch 1 wobei ein Teil des Metalles von der Anode einer elektrischen Bogenentladung verdampft im Dampfform übergeführt wird.

6. Verfahren nach Patentanspruch 1 wobei die Beschichtung in einer reaktiven Atmosphäre durchgeführt wird.

## Claims

1. A process for applying layers to substrates wherein in a vacuum chamber layer material is converted into a gaseous state by means of at least two different means and deposited on the substrates, forming a layer, wherein a part of the material is converted into the vapour form by an electrical arc discharge and another part of the material is converted into the vapour form by a magnetic field-supported cathode sputtering step which is independent of the arc discharge, and on average in respect of time at least five atomic percent of the metal component to be applied to the functional surfaces of the substrates come from the conversion of electrode material of the arc discharge into the vapour form, wherein the layer is formed on the functional surfaces of the substrate continuously or in rapid succession alternately from material of the arc discharge and the cathode sputtering.

2. A process according to claim 1 wherein at least 5 out of 100 atoms of the impinging layer-forming metal component comes at any time from the conversion of electrode material of the arc discharge into the vapour form.

3. A process according to claim 1 wherein the periods in which the deposit of metal vapour on the functional surfaces which are to be coated on the substrates originates to a proportion of more than 95 out of 100 parts from the magnetic field-supported cathode sputtering step are so short that not more than 30 nanometres of layer are deposited on said functional surfaces during said periods.

4. A process according to claim 1 wherein a part of the metal from the cathode of an electrical arc discharge is converted into vapour form.

5. A process according to claim 1 wherein a part of the metal from the anode of an electrical arc discharge is converted into vapour form.

6. A process according to claim 1 wherein the coating operation is carried out in a reactive atmosphere.

## Revendications

1. Procédé pour déposer des couches sur des substrats, selon lequel un matériau destiné à former une couche est transformé à l'état gazeux dans une chambre à vide à l'aide d'au moins deux dispositifs différents et déposé sur les substrats en formant une couche, étant précisé qu'une partie du matériau est transformée sous forme de vapeur par une décharge électrique en arc et une autre partie par une pulvérisation cathodique à l'aide d'un champ magnétique indépendante de la décharge en arc, et qu'en moyenne dans le temps, au moins cinq pour cent d'atomes de la part de métal à déposer sur les surfaces fonctionnelles des substrats proviennent de la transformation sous forme de vapeur d'un matériau d'électrode du dispositif de décharge en arc, la couche étant formée sur les surfaces fonctionnelles des substrats de façon continue ou avec une alternance rapide à partir du matériau de la décharge en arc et de la pulvérisation cathodique.

2. Procédé selon la revendication 1, selon lequel 5 atomes sur 100 de la part de métal constitutive de couche, bombardée proviennent en permanence de la transformation sous forme de vapeur d'un matériau d'électrode du dispositif de décharge en arc.

3. Procédé selon la revendication 1, selon lequel les périodes au cours desquelles le dépôt de vapeur métallique sur les surfaces fonctionnelles à revêtir des substrats provient pour plus de 95 parties sur 100 de la pulvérisation cathodique assistée par champ magnétique, sont suffisamment courtes pour que, pendant celles-ci, il ne se dépose pas sur ces surfaces fonctionnelles une couche de plus de 30 nanomètres.

4. Procédé selon la revendication 1, selon lequel une partie du métal de la cathode d'un dispositif de décharge électrique en arc est transformée sous forme de vapeur.

5. Procédé selon la revendication 1, selon lequel une partie du métal de l'anode d'un dispositif de décharge électrique en arc est transformée en étant vaporisée sous forme de vapeur.

6. Procédé selon la revendication 1, selon lequel le revêtement est réalisé dans une atmosphère réactive.
